Europäisches Patentamt

European Patent Office

Office européen des brevets

(11) Veröffentlichungsnummer: **0 379 924**

**A2**

# (12) EUROPÄISCHE PATENTANMELDUNG

(21) Anmeldenummer: 90100749.2

(22) Anmeldetag: 15.01.90

(51) Int. Cl.⁵: **G03F 7/09**

(30) Priorität: 23.01.89 DE 3901863

(43) Veröffentlichungstag der Anmeldung:
01.08.90 Patentblatt 90/31

(84) Benannte Vertragsstaaten:
DE FR GB IT

(71) Anmelder: **Siemens Aktiengesellschaft
Wittelsbacherplatz 2
D-8000 München 2(DE)**

(72) Erfinder: **Nölscher, Christoph, Dr.
Hegelstrasse 4
D-8000 München 83(DE)**
Erfinder: **Mader, Leonard, Dr.
Defreggerstrasse 17
D-8012 Ottobrunn(DE)**

(54) Vefahren zur Verringerung reflektionsbedingter Srukturgrössenschwankungen in einer Deckschicht bei der in der Herstellung integrierten Schaltungen in einem Substrat verwendeten optischen Lithographie.

(57) Zur Verringerung reflexionsbedingter Strukturgrößenschwankungen in einer Deckschicht (1), z. B. aus Fotolack, bei der Herstellung integrierter Schaltungen in einem Substrat (3), z. B. aus Silizium, mit Hilfe optischer Lithographie wird unter die Deckschicht (1) eine Antireflexschicht (2) aufgebracht. Eine Ausführungsform der Antireflexschicht (2) besteht durchgehend aus einem Material, z. B. $Si_3N_4$, das einen Brechungsindex hat, der größer ist als derjenige der Deckschicht (1), und weist eine Dicke auf, die einem Viertel der Wellenlänge des zur Belichtung verwendeten Lichtes entspricht. Eine weitere Ausführungsform der Antireflexschicht (2) ist aus einer ersten Schicht (21) aus z. B. $SiO_xN_y$ und einer zweiten Schicht (22) aus z. B. $SiO_2$ zusammengesetzt, wobei die unter der Deckschicht (1) liegende erste Schicht (21) einen größeren Brechungsindex aufweist als die Deckschicht (1), die unter der ersten Schicht (21) liegende zweite Schicht (22) einen kleineren Brechungsindex aufweist als die erste Schicht (21) und das unter der zweiten Schicht (22) angeordnete Substrat (3) einen größeren Brechungsindex als das Substrat (3) aufweist.

FIG1

# Verfahren zur Verringerung reflektionsbedingter Strukturgrößenschwankungen in einer Deckschicht bei der in der Herstellung integrierter Schaltungen in einem Substrat verwendeten optischen Lithographie.

Die Erfindung betrifft ein Verfahren zur Verringerung reflektionsbedingter Strukturgrößenschwankungen in einer auf einer Silizium, amorphe Silizium- haltige Legierungen und/oder Silicide enthaltenden Schicht angeordneten Deckschicht, wie sie bei der optischen Lithographie bei der Herstellung integrierter Schaltungen in einem Substrat verwendet wird.

Bei der Herstellung integrierter Schaltungen wird ein Halbleiterschichtaufbau, der als oberste Schicht eine Fotolackschicht aufweist, durch eine Fotomaske belichtet. Ein Teil des zur Belichtung verwendeten Lichtes wird in der Fotolackschicht absorbiert. Ein Teil des Lichtes wird an der Grenzschicht der Fotolackschicht zur darunter liegenden Schicht reflektiert. Ein Teil dringt in die unter der Fotolackschicht liegenden Schichten ein und wird wiederum an Grenzschichten teilweise reflektiert. Das an Schichtgrenzen reflektierte Licht strahlt von der Rückseite wieder in die Fotolackschicht ein. Dadurch kommt es zu einer unerwünschten zweiten Belichtung der Fotolackschicht, die je nach Interferenzbedingung Intensitätsschwankungen und damit Strukturgrößenschwankungen zur Folge hat.

Diese Strukturgrößenschwankungen wurden in der Herstellung integrierter Schaltungen bislang dadurch berücksichtigt, daß entweder Designs mit größeren Toleranzen und damit größerer Fläche verwendet wurden oder daß die Designregeln verletzt wurden, was zu Ausbeuteminderungen führt.

Aus der Optik ist die Verwendung von Lambdaviertelschichten aus dielektrischem Material zur Reflexminderung dielektrischer Schichten z. B. auf Brillen oder Objektiven bekannt (s. z. B. Max Born Emil Wolf, Principles of Optics, Pergamon Press, Oxford, 6. Ausgabe, 1980, Kapitel 1.6, O.S. Heavens, Optical Properties of thin solid films, New York, 1954, Chapter 4, H.A.M. van den Berg, J.B. van Staden: Antireflection coatings on metal layers for photolithographic purposes, J. Appl. Phys. 50 (1979) 1212, L. Mader, D. Widmann, W. G. Oldham: Reduction of linewidth variations in optical projection printing, Lausanne, Schweiz, (1981), p. 105).

Aufgabe der Erfindung ist es, ein Verfahren zur Verringerung reflektionsbedingter Strukturgrößenschwankungen in der optischen Lithographie anzugeben, das in den Herstellprozeß integrierter Schaltungen leicht einzufügen ist und das die Einhaltung engerer Toleranzen und die Erzeugung feinerer Strukturen ermöglicht.

Die Aufgabe wird erfindungsgemäß gelöst durch ein Verfahren der eingangs genannten Art bei dem unter die Deckschicht eine Antireflexschicht aufgebracht wird.

Die Verwendung der Antireflexschicht unter der Deckschicht aus z. B. Fotolack verhindert eine Rückreflexion des Lichtes in die Fotolackschicht.

Es liegt im Rahmen der Erfindung, die Antireflexschicht durchgehend aus einem Material vorzusehen, wobei das Material einen größeren Brechungsindex als die Deckschicht aufweist. Die Antireflexschicht wird in diesem Fall in einer Dicke aufgebracht, die einem Viertel der Wellenlänge des bei der Belichtung verwendeten Lichtes entspricht. Bei der Verwendung einer Antireflexschicht aus $Si_3N_4$ in dieser Dicke auf einem Substrat aus Polysilizium oder amorphem, mit Molybdän implamtierten Silizium wird eine Reflexminderung von etwa 60 % erzielt.

Der Einsatz einer solchen Schicht ist jedoch aus prozeßtechnischen Gründen und Gründen der Chipqualität nicht immer möglich. Eine $Si_3N_4$-Schicht kann auf einem Siliziumsubstrat Kristalldefekte erzeugen. Ferner kann auf dem Siliziumsubstrat von vornherein eine Siliziumoxidschicht bestimmter Dicke vorhanden sein, die erst entfernt werden müßte oder auf eine Dicke, die der Hälfte der Wellenlänge entspricht, aufgedickt werden müßte, ehe eine Lamdaviertelschicht aus z. B. $Si_3N_4$ abgeschieden werden kann. In einem solchen Fall wird eine aus einer ersten Schicht und einer zweiten Schicht zusammengesetzte Antireflexschicht verwendet. Dabei weist die unter der Deckschicht liegende erste Schicht einen größeren Brechungsindex auf als die Deckschicht, die unter der ersten Schicht liegende zweite Schicht einen kleineren Brechungsindex auf als die erste Schicht und das unter der zweiten Schicht angeordnete Substrat einen größeren Brechungsindex als die zweite Schicht auf. Mit Hilfe von Simulationsrechnungen mit dem Programm SAMPLE konnte gezeigt werden, daß eine solche Kombination aus zwei Schichten eine ähnliche Reflexionsminderung bewirkt wie eine Lamdaviertelschicht. Die erste Schicht besteht z. B. aus $SiO_xN_y$, wobei x und y beliebige Zahlen größer oder gleich 0 sind. Die zweite Schicht besteht z. B. aus $SiO_2$. Das Substrat besteht z. B. aus Silizium. Die Deckschicht besteht z. B. aus $SiO_2$ oder aus Fotolack. Es ist auch möglich, eine Deckschicht, die aus einer $SiO_2$-Schicht und einer Fotolackschicht zusammengesetzt ist, zu verwenden.

Im folgenden wird die Erfindung anhand von einem Ausführungsbeispiel und Figuren näher erläutert.

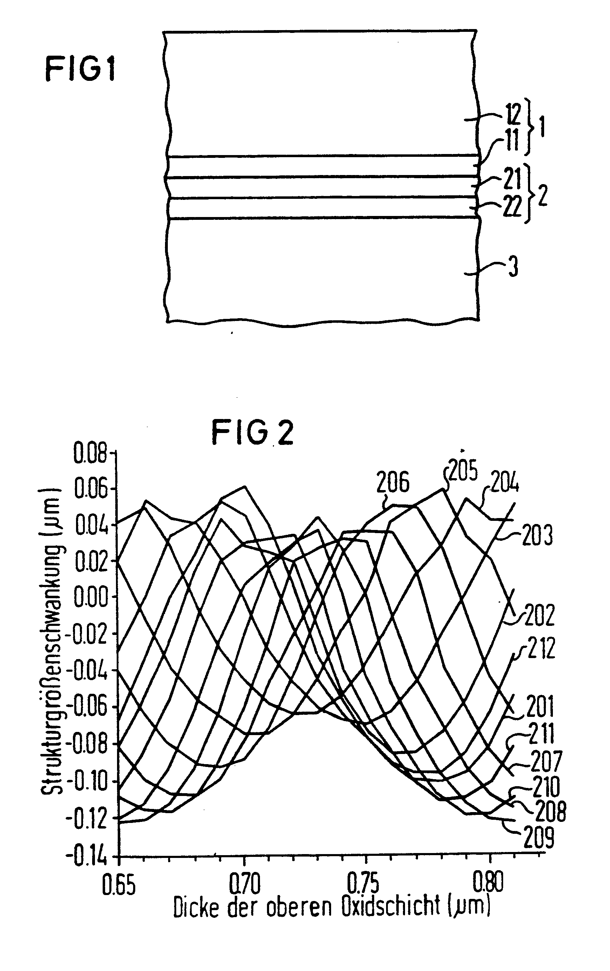

Fig. 2 bis Fig. 6 zeigen Ergebnisse von Simulationsrechnungen.

In Fig. 1 ist ein Substrat 3 dargestellt. Das Substrat 3 besteht z. B. aus Silizium, polykristallinem Silizium oder Silicid. Auf das Substrat 3 wird eine Antireflexschicht 2 aufgebracht. Die Antireflexschicht 2 ist aus einer ersten Schicht 21 und einer zweiten Schicht 22 zusammengesetzt. Dabei besteht die erste Schicht 21 z. B. aus $SiO_xN_y$, wobei x und y beliebige Zahlen größer oder gleich 0 sind. Die zweite Schicht 22 besteht z. B. aus $SiO_2$. Durch die Stöchiometrie der ersten Schicht 21 kann der Brechungsindex eingestellt werden. Auf die Antireflexschicht 2 folgt eine Deckschicht 1. Die Deckschicht 1 ist zusammengesetzt aus einer oberen Oxidschicht 11, die unmittelbar auf die Antireflexschicht 2 folgt, und aus einer Fotolackschicht 12 die oberhalb der oberen Oxidschicht 11 angeordnet ist. Dabei hat die zweite Schicht 22 einen kleineren Brechungsindex als das Substrat 3, die erste Schicht 21 einen größeren Brechungsindex als die zweite Schicht 22 und die obere Oxidschicht 11 einen kleineren Brechungsindex als die erste Schicht 21.

Fig. 2 zeigt das Ergebnis von Simulationsrechnungen für die Strukturgrößenschwankungen in einem Aufbau mit folgenden Schichtdicken: Die Fotolackschicht 12 hat eine Dicke von 1,47 µm. Die Dicke der oberen Oxidschicht 11 sowie der ersten Schicht 21, die aus $Si_3N_4$ besteht, sind variabel. Die Dicke der zweiten Schicht 22 beträgt 25 Nanometer. Aufgetragen sind die Strukturgrößenschwankungen in µm als Funktion der Dicke der oberen Oxidschicht 11 in µm. Die Dicke der ersten Schicht 21 ändert sich von Kurve zu Kurve, wobei für die Kurve 201 eine Dicke von 0 Nanometer, für die Kurve 212 eine Dicke von 110 Nanometer und für die übrigen Kurven mit ansteigender Nummerierung eine Dicke, die jeweils um 10 Nanometer größer als die der vorangehenden Kurve ist, zugrunde gelegt wurde. Dem Diagramm ist zu entnehmen, daß für vorgegebene Dicke der zweiten Schicht 22 es jeweils eine optimale Dicke der ersten Schicht 21 gibt, die größte Sicherheit gegen Strukturgrößenschwankungen aufgrund von Schwankungen der Dicke der oberen Oxidschicht 11 gewährleistet.

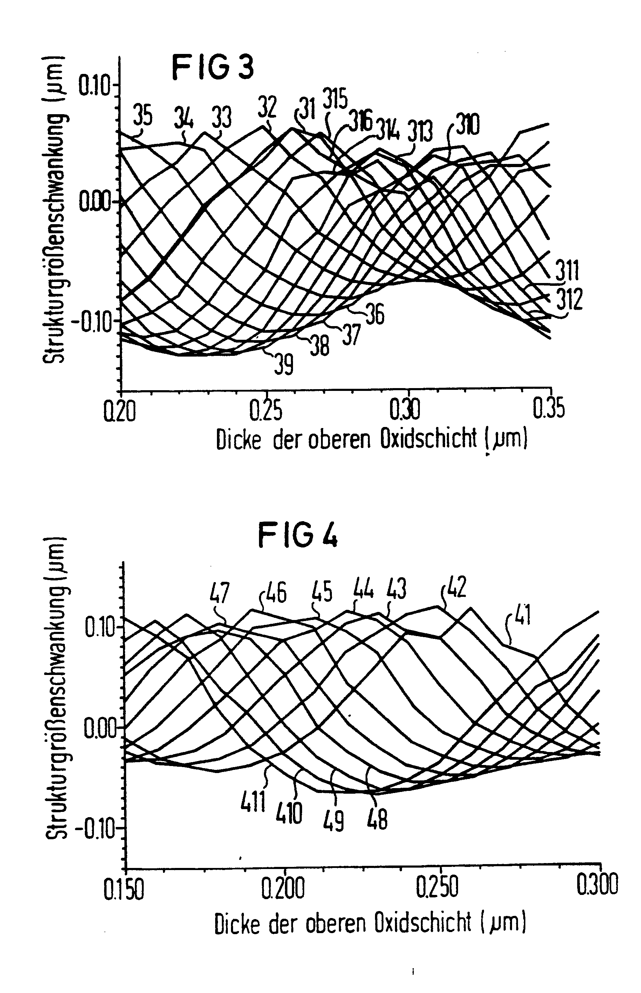

Fig. 3 zeigt das Ergebnis von Simulationsrechnungen der Strukturgrößenschwankungen in Abhängigkeit der Dicke der oberen Oxidschicht, wobei die Dicke der ersten Schicht, die aus $Si_3N_4$ besteht, fest mit 20 Nanometer zugrunde gelegt wurde und die Dicke der zweiten Schicht zwischen 0 und 150 Nanometer variiert wurde. Die Kurve 31 entspricht einer Dicke von 0 Nanometer die weiteren Kurven entsprechen einer Dicke die mit jeder Ordnungszahl um 10 Nanometer größer ist. Die Kurve 316 entspricht daher einer Schichtdicke von 150 Nanometer. Auch diesem Diagramm ist zu entnehmen, daß bei vorgegebener Dicke der ersten Schicht sich eine optimale Dicke für die zweite Schicht finden läßt.

Fig. 4 zeigt das Ergebnis einer Simulationsrechnung der Strukturgrößenschwankung in Abhängigkeit der Dicke der oberen Oxidschicht 11, wobei wiederum die Dicke der ersten Schicht 21 mit 20 Nanometer fest zugrunde gelegt wird. Die erste Schicht 21 besteht in dieser Rechnung jedoch aus $SiO_xN_y$, was einem Brechungsindex von 1,8 entspricht gegenüber dem Brechungsindex von $Si_3N_4$ von n = 2,05. Der von Kurve zu Kurve variierte Parameter ist wiederum die Dicke der zweiten Schicht 22. Die Dicke der zweiten Schicht 22 wird zwischen 0 Nanometer in Kurve 41 und 100 Nanometer in Kurve 411 variiert. Mit ansteigender Kurvennummerierung ändert sich die Dicke jeweils um 10 Nanometer. Für diese Rechnung wurde eine Fotolackdicke von 1,57 µm zugrunde gelegt.

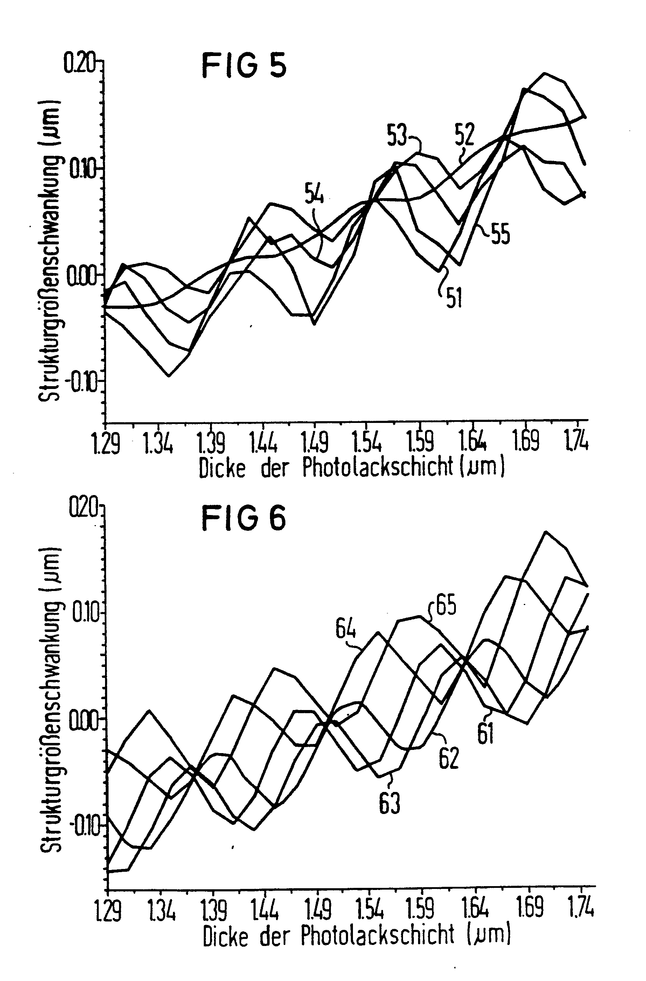

In Fig. 5 und Fig. 6 sind Simulationsrechnungen für Strukturgrößenschwankungen dargestellt, die eine erste Schicht 21 aus $SiO_xN_y$ mit x = y = 0 zugrundelegen. In dieser Rechnung besteht die Deckschicht 1 nur aus der Fotolackschicht 12. In Fig. 5 ist das Ergebnis dargestellt in Abhängigkeit der Dicke der Fotolackschicht 12 für eine Dicke der ersten Schicht 21 von 5 Nanometer, wobei die Dicke der zweiten Schicht 22 zwischen 0 Nanometer in Kurve 51 und 112 Nanometer in Kurve 55 in Schritten von 28 Nanometern variiert wurde. Aufsteigende Kurvennummerierung entspricht größerer Dicke. Zum Vergleich ist in Fig. 6 die Strukturgrößenschwankung als Funktion der Dicke der Fotolackschicht 12 dargestellt für eine Dicke der ersten Schicht 21 von 0 Nanometer, wobei wiederum die Dicke der zweiten Schicht 22 zwischen 0 Nanometer in Kurve 61 und 112 Nanometer in Kurve 65 in Schritten von 28 Nanometern variiert wurde. Ein Vergleich der beiden Diagramme zeigt, daß eine Antireflexschicht bestehend aus einer Schichtkombination aus amorphem Silizium und aus $SiO_2$ - (jeweils bestimmte Dicke) sehr gute Antireflexwirkung hat.

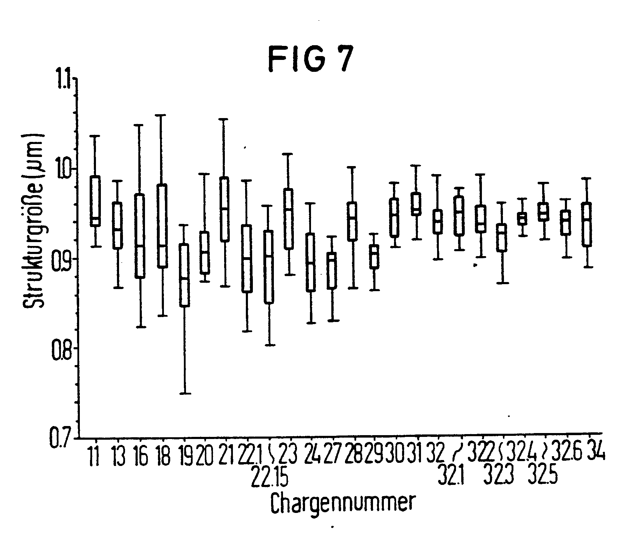

In Fig. 7 ist das Ergebnis von Messungen dargestellt, die die Wirksamkeit des erfindungsgemäßen Verfahrens belegen. An verschiedenen Chargen wurden die auftretenden Strukturgrößen gemessen. In Fig. 7 ist für die einzelnen Chargen, dargestellt als Chargennummer, der Meßbereiche der Strukturgrößen dargestellt. Dabei liegen 75 % der Meßpunkte innerhalb des länglichen Kastens. Der Mittelwert ist als Querstrich dargestellt. Die Chargen 11 bis 24 wurden nach den konventionellen Verfahren ohne Antireflexschicht hergestellt. Die Chargen 27 bis 32.3 sowie 32.6 und 34 wurden nach einem Verfahren ohne Antireflexschicht hergestellt jedoch mit einer verbesserten Oxidabscheidung, die eine konstante Oxiddicke sicherstellt. Die Chargen 32.4 und 32.5 wurden nach dem erfindungsgemäßen Verfahren hergestellt mit einer Antireflexschicht, die aus einer 25 nm dicken $SiO_2$-Schicht als zweiter Schicht 22 und einer 28 nm dicken $Si_3N_4$-Schicht als erster Schicht 21 hergestellt wurden. Für die Chargen 11 bis 24 beträgt die mittlere quadratische Abweichung 45 nm. Für die Chargen 27 bis 32.3 sowie 32.6 und 34 beträgt die mittlere quadratische Abweichung 23 nm. Für die Chargen 32.4 und 32.5, die nach dem erfindungsgemäßen Verfahren hergestellt wurden, beträgt die mittlere quadratische Abweichung 13 nm. Die Messung zeigt deutlich, daß eine drastische Reduktion der Schwankungen in der Strukturgröße durch das erfindungsgemäße Verfahren erzielt werden kann.

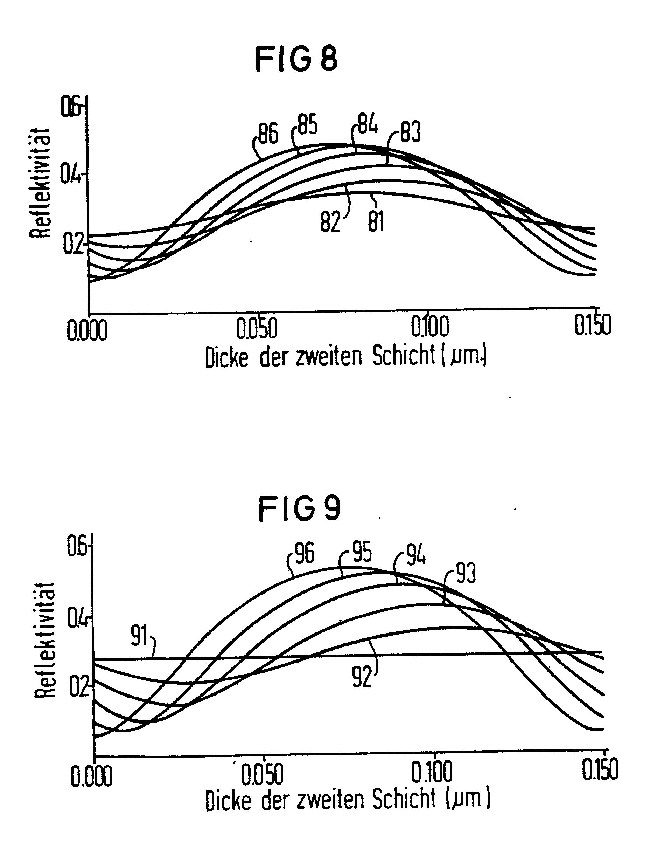

In Fig. 8 ist das Ergebnis einer Simulationsrechnung dargestellt. Es wurde die Reflektivität, d. h. die reflektierte Lichtintensität geteilt durch die eingestrahlte Lichtintensität berechnet für ein Schichtsystem, das als Deckschicht Fotolack, als erste Schicht $Si_3N_4$ und als zweite Schicht $SiO_2$ enthält. Dargestellt ist die Reflektivität als Funktion der Dicke der zweiten Schicht. Parameter für die Kurvenschar ist die Dicke der ersten Schicht. Die Kurve 81 ist für eine Dicke von 0 nm berechnet, die Kurve 82 für eine Dicke von 10 nm, die Kurve 83 für eine Dicke von 20 nm, die Kurve 84 für eine Dicke von 30 nm, die Kurve 85 für eine Dicke von 40 nm und die Kurve 86 für eine Dicke von 53 nm. Aus der Figur kann für vorgegebene Dicke der ersten Schicht aus $Si_3N_4$ abgelesen werden, welche Dicke der zweiten Schicht zu minimaler Reflektivität führt.

In Fig. 9 ist das Ergebnis einer weiteren Simulationsrechnung dargestellt. Berechnet wurde die Reflektivität (definiert wie bei Fig. 8) an einem Schichtaufbau bestehend aus einer Deckschicht aus $SiO_2$, einer ersten Schicht aus $Si_3N_4$ und einer zweiten Schicht $SiO_2$ auf einem Siliziumsubstrat als Funktion der Dicke der zweiten Schicht. Parameter für die Kurvenschar ist die Dicke der ersten Schicht. Für die Kurve 91 wurde eine Dicke von 0 nm zugrundegelegt, für die Kurve 92 von 10 nm, für die Kurve 93 von nm, für die Kurve 94 von 30 nm, für die Kurve 95 von 40 nm und für die Kurve 96 von 53 nm. Der Figur kann zu vorgegebener Dicke der ersten Schicht die optimale Dicke der zweiten Schicht entnommen werden, bei der minimale Reflektivität erzielt wird.

**Ansprüche**

1. Verfahren zur Verringerung reflexionsbedingter Strukturgrößenschwankungen in einer auf einer Silizium, amorphe Siliziumhaltige Legierungen und/oder Silicide enthaltenden Schicht angeordneten Deckschicht, wie sie bei der optischen Lithographie bei der Herstellung integrierter Schaltungen in einem Substrat verwendet wird,

**dadurch gekennzeichnet, daß** unter die Deckschicht (1) eine Antireflexschicht (2) aufgebracht wird.

2. Verfahren nach Anspruch 1,

**dadurch gekennzeichnet, daß** die Antireflexschicht (2) durchgehend aus ein und demselben Material bestehend, das einen größeren Brechungsindex als die Deckschicht (1) aufweist, in einer Dicke aufgebracht wird, die einem Viertel der Wellenlänge des bei der Belichtung verwendeten Lichtes beträgt.

3. Verfahren nach Anspruch 1,

**dadurch gekennzeichnet, daß** die Antireflexschicht (2) zusammengesetzt aus einer ersten Schicht (21) und einer zweiten Schicht (22) aufgebracht wird, wobei die unter der Deckschicht (1) liegende erste Schicht (21) einen größeren Brechungsindex aufweist als die Deckschicht (1), die unter der ersten Schicht (21) liegende zweite Schicht (22) einen kleineren Brechungsindex aufweist als die erste Schicht (21) und das unter der zweiten Schicht (22) angeordnete Substrat (3) einen größeren Brechungsindex aufweist als die zweite Schicht (22), wobei die zweite Schicht aus nichtabsorbierendem Material besteht.

4. Verfahren nach Anspruch 3,

**dadurch gekennzeichnet, daß** als Deckschicht (1) eine Fotolackschicht, als erste Schicht (21) eine nichtabsorbierende $SiO_xN_y$-Schicht (x, y beliebige Zahlen größer oder gleich 0), oder eine absorbierende Schicht aus amorphem Silizium, als zweite Schicht (22) eine $SiO_2$-Schicht und als Substrat (3) ein Siliziumsubstrat verwendet wird.

5. Verfahren nach Anspruch 3,

**dadurch gekennzeichnet, daß** als Deckschicht (1) eine Fotolackschicht, als erste Schicht (21) eine nichtabsorbierende $Si_3N_4$-Schicht, als zweite Schicht (22) eine $SiO_2$-Schicht und als Substrat (3) ein Siliziumsubstrat verwendet wird und daß wenn die erste Schicht (21) eine Dicke zwischen $0,004\lambda/n$ und $0.0175\ \lambda/n$ oder $0,242\ \lambda/n$ und $0,374\ \lambda/n$ aufweist, die zweite Schicht (22) eine Dicke zwischen $0\ \lambda/n$ und $0,117\ \lambda/n$ aufweist und wenn die erste Schicht (21) eine Dicke zwischen $0,175\ \lambda/n$ und $0,238\ \lambda/n$ aufweist, die zweite Schicht eine Dicke kleiner als $0,078\ \lambda/n$ aufweist, wobei n der Brechungsindex der jeweiligen Schicht ist.

## FIG 1

## FIG 2

FIG 3

FIG 4

FIG 5

FIG 6

FIG 7

# FIG 8

Reflektivität

06
04
02

86 85 84 83
82 81

0.000    0.050    0.100    0.150

Dicke der zweiten Schicht (µm.)

# FIG 9

Reflektivität

06
04
02

96 95 94 93
91
92

0.000    0.050    0.100    0.150

Dicke der zweiten Schicht (µm)